# EUROPEAN PATENT SPECIFICATION

(11) **EP 1 521 811 B1**
(45) Date of publication and mention of the grant of the patent: **02.12.2009**
(21) Application number: 03730448.2
(22) Date of filing: 12.06.2003
(51) Int. Cl.: C09D 11/00

(54) **A METHOD FOR THE PRODUCTION OF CONDUCTIVE AND TRANSPARENT NANO-COATINGS AND NANO-POWDER COATINGS**
EIN VERFAHREN ZUR HERSTELLUNG VON TRANSPARENTEN UND LEITFÄHIGEN NANO-BESCHICHTUNGEN UND NANO-PULVERBESCHICHTUNGEN
PROCEDE DE FABRICATION DE NANO-REVETEMENTS, DE REVETEMENTS ET DE NANO-POUDRES CONDUCTEURS ET TRANSPARENTS

(30) Priority: 13.06.2002 US 387919 P
(43) Date of publication of application: 13.04.2005
(73) Proprietor: NanoPowders Industries Ltd., Caesarea, 38900 (IL)
(72) Inventor: GARBAR, Arkady, 20692 Yoqneam Illit (IL); DE LA VEGA, Fernando, 30900 Zichron Yacov (IL); MATZNER, Einat, 17940 Adi (IL)
(74) Representative: Vossius & Partner
(86) International application number: PCT/IL2003/000502
(87) International publication number: WO 2003/106573

(56) References cited:
- EP-A- 1 323 793
- WO-A-03/038002
- US-A- 5 922 403
- WUELFING W P ET AL: "MONOLAYER-PROTECTED CLUSTERS: MOLECULAR PRECURSORS TO METAL FILMS" CHEMISTRY OF MATERIALS, AMERICAN CHEMICAL SOCIETY, WASHINGTON, US, vol. 13, no. 1, 2001, pages 87-95, XP008015550 ISSN: 0897-4756

## Description

### FIELD OF THE INVENTION

The present invention generally relates to a method for the production of transparent conductive coatings and inks and nano-powder coatings and inks obtained by this method.

### BACKGROUND OF THE INVENTION

Nano particles, especially metal nano particles have very special properties which are directly related to their dimensions and to the fact that a large ratio of the atoms in the particle are in the surface of the particle or at particle and grain boundaries. These properties include optical properties, sintering and diffusion properties, electrical properties like capacitance, impedance and resistance, catalytic activity and many others.

These improved properties have a range of uses and applications; e.g. catalysts for chemical reactions, electrodes, fuel cells, medical devices, water cleaning technologies, electronic devices, coatings, and more.

U.S. Pat. 5,476,535 to the applicant present a method for the production of nano-powders, especially of silver. This process comprising the steps of (a) forming an aluminum-silver alloy of a specific blend composition; (b) leaching the aluminum ingredient by a series of consequent leaching steps wherein a fresh leaching agent is reacting the treated solid material, providing a gradually porous and homogeneous silver alloy. Ultrasonic oscillations are applied in step (c), disintegrating the agglomerate and enhancing the penetration of the leaching agent into the ever growing porous of the alloy by the application of a plurality of ultrasonic oscillations. The leaching agent is leaving silver agglomerate in step (d), and then the agglomerate is washed and dried in a final step.

According to U.S. Pat. No. 6,012,658 to the applicant et al., the very same process was used as is to form metal flakes. Thus, the following two main steps were introduced: comminuting the alloys obtained by the aforementioned U.S. Pat No. 5,476,535 into defined particles, and then faltering the obtained particles into strip-like highly porous alloys of predetermined characteristics.

### SUMMARY OF THE INVENTION

The scope of the present invention is defined by the features of the claims. It is the core of the present invention to provide useful and novel a method for coating a substrate by conductive and/or transparent nano-powders in either ordered or random pattern, wherein said pattern is obtained either spontaneously or as a result of a printing technique. It is well in the scope of the present invention to use of nano metal additive to produce a transparent-conductive coating such in the case of nano titanium dioxide additive that was proved useful for the production of coatings transparent to visible light and opaque to UV wave lengths; in the case of nano silica additive, that was found useful for the production of transparent coatings with special resistance performance; and in the case of nano pigments, that proved useful for the production of transparent colored coatings.

It is also an object of the present invention to provide a useful and novel method for the production of conductive and transparent coatings comprising metal nano-powders. Said method comprising the steps of (i) admixing metal nano powder in an organic solvent with at least one ingredient of the group: binder, surfactant, additive, polymer, buffer, dispersant and/or coupling agent in the manner a homogenized solution is obtained; (ii) admixing the homogenized mixture with water, water-miscible solvent, or mixture of water-miscible solvents in the manner that a water/oil (w/o) type emulsion is formed; (iii) applying the emulsion mixture obtained above on a surface to be coated, e.g., by various manners: screen printing, spreading, spin coating, dipping etc.; (iv) evaporating the solvent from the emulsion in the manner that a self-assembled network-like pattern is developed in situ ; and (v) sintering the network-like pattern to form a conductive and transparent coating on the surface.

It is in the scope of the present invention wherein the metal nano powders are used alone or in combination with conductivity improving additive selected from at least one of the group: metal colloids and/or metal reducible salt and/or organic metal complexes and/or organo metal compounds which decompose to form conductive materials. Preferably, the concentration of the metal nano powder in the admixed solution is between 1% (wt) to 50% (wt) and more particularly, in the range of 2% (wt) to 10% (wt). According to the present invention the admixed solution comprises an organic solvent or a mixture of organic solvents. Those organic solvents are characterized by an evaporation rate higher than the evaporation rate of water at ambient conditions. The concentration of the organic solvent or the mixture of organic solvents in the admixed solution is between 20% (wt) to 85% (wt). More specifically, their concentration in the narrow range 40% (wt) to 80% (wt). It is acknowledged in this respect that the solvents can be selected from at least one of the group of petroleum ether, hexanes, heptanes, toluene, benzine, dichloroethane, trichloroethylene, chloroform, dichloromethane, nitromethane, dibromomethane, cyclopentanone, cyclohexanone or any mixture thereof.

The concentration of the aforementioned binder in the admixed solution may be between 0% (wt) to 3% (wt). Preferably (but not limited to), the binder is selected from ethyl cellulose and/or modified urea.

It another object of the present invention to provide a useful and novel method for the production of ink or solution comprising metal nano-powders for the producing of transparent and conductive coatings. This method is in principle similar to the one defined above, and comprising the following steps: (i) admixing metal nano powder in a an organic solvent with at least one ingredient of the group: binder, surfactant, additive, polymer, buffer, dispersant and/or coupling agent in the manner a homogenized solution is obtained; (ii) admixing said homogenized mixture with water or water miscible solvent or mixture of water miscible solvents in the manner a W/O type emulsion is obtained (iii) applying the emulsion obtained above on said surface to be coated, e.g., by spreading, spin coating, dipping etc.; (iv) evaporating the solvent from said homogenized mixture in the manner that a self-assembled network-like pattern is developed *in situ*; and lastly, (v) sintering the network-like pattern so a conductive and transparent coating is obtained.

The concentration of the aforementioned surfactant or surfactants mixture may be between 0% (wt) to 4% (wt) and/or wherein the concentration of the surfactant or surfactants mixture in the dispersed emulsion is between 0% (wt) to 4% (wt). Preferably, W/O emulsion is obtained by said methods..

It is further in the scope of the present invention wherein the concentration of the water miscible solvent or mixture of water miscible solvents in the dispersed emulsion is between 5% (wt) to 70% (wt). Preferably (but not limited to), the surfactant or surfactants mixture defined above comprising at least one of the group of non ionic and ionic compounds, selected from SPAN-20, SPAN-80, glyceryl monooleate, sodium dodecyl sulfate, or any combination thereof. Moreover, it is also in the scope of the present invention wherein the concentration of the water miscible solvent or mixture of water miscible solvents in the dispersed emulsion is between 15% (wt) to 55% (wt).

The aforementioned water miscible solvent or solvent mixture may be selected from (but not limited to) at least one of the group of water, methanol, ethanol, ethylene glycol, glycerol, dimethylformamid, dimethylacetamid, acetonitrile, dimethylsulfoxide, N-methylpyrrolidone or any mixture thereof.

The surface to be coated may be selected from glass, either flexible or relatively non-flexible polymeric films or sheets or any combination thereof. The polymeric film may comprise at least one of the group of polyesters, polyamides, polyimides, polycarbonates, polyethylene, polyethylene products, polypropylene, acrylate containing products, polymethyl metaacrylates (PMMA) their copolymers or any combination thereof and any other transparent substrate. Additionally or alternatively, the method defined above may comprise another step of treating the surface to be coated by a means of corona treatment and/or coating by primer.

The aforementioned primer may be selected (but not limited to) from at least one of the group of 3-aminopropyl triethoxy silane, phenyl trimethoxysilane, glycidyl trimethoxysilane, commercially available Tween products, Tween-80, neoalkoxy tri(dioctylpmpylphosphato) titanate or any combination thereof.

It is further in the scope of the present invention wherein the aforementioned nano-powder comprising metal or a mixture of metals selected from (but not limited to) silver, gold, platinum, palladium, nickel, cobalt, copper or any combination thereof.

The spreading of the homogenized mixture on a surface to be coated may be provided by a means selected from simple spreading; immersing; spin coating; dipping or any other suitable technique. Moreover, according to one embodiment, the step of coating layer or layers provided by the spreading of the homogenized mixture on a surface to be coated is provided for a wet thickness of 5 to 200 microns.

The sintering of the evaporated homogenized solution is provided in the temperature range of 50°C to 300°C for 0.5 to 2 hours. Alternatively, the sintering of the network-like pattern is provided in the temperature range of 50°C to 150°C for 2 to 30 minutes.

It another object of the present invention to provide a cost-effective and novel conductive and transparent coating layer comprising metal nano powders, produce in the method as defined in claim 1 or in any of its preceding claims. Additionally or alternatively, a conductive and transparent ink or coating layer or layers is provided by the present invention, and is characterized by self-assembled network pattern.

It is thus also in the scope of the present invention wherein the aforementioned conductive and transparent coating layer is characterized by light transparencies in the range of 40% to 90% at 400 nm to 700 nm wavelength, resistances in the range of 0.1 Ω /square to 9000 Ω/square and by haze value in the range of 0.5% to 10%; and wherein the conductive and transparent ink layer is characterized by light transparencies in the range of 10% to 90% at 400 nm to 700 nm wavelength; resistances in the range of 0.1 Ω/square to 1,000 Ω/square, and by a haze value in the range of 0.1% to 5%.

It is further in the scope of the present invention wherein the conductive and transparent coating layer defined above is characterized by either ordered or random patterns, wherein said patterns are provided by printing, ink-jet printing, ink-jet disposition, self-assembling or self organizing or any other suitable technique. Said conductive and transparent coating layer or the multiple layer array may further characterized by that if provided a protective layer, anti-scratch layer, a layer of an enhance conductivity, a layer of an enhance adhesion to a surface to be coated or any combination thereof. Moreover, the obtained conductive and transparent coating layer or the aforementioned multiple layer array may be especially adapted to be use in at least one of the group of screens, displays, electrodes, PCBs, ink-jet products, ink-jet disposition products, smart cards, RFID, antenna, thin-film transistors, LCDs or any combination thereof.

### BRIEF DESCRIPTION OF THE FIGURES

In order to understand the invention and to see how it may be carried out in practice, preferred embodiments will now be described, by way of non-limiting example only, with reference to the accompanying drawings, in which:
- Figure 1: presenting a view taken by a means of a light microscope showing the self-assembling pattern of an ink disposed on a glass surface as obtained by the method of one embodiment of the present invention;
- Figure 2: presenting a view taken by a means of a light microscope showing the self-assembling pattern of an ink disposed on a glass surface as obtained by the method of another embodiment of the present invention;
- Figure 3: presenting a view taken by a means of a light microscope showing the self-assembling pattern of an ink disposed on a glass surface as obtained by the method of another embodiment of the present invention;
- Figure 4: presenting a view taken by a means of a light microscope showing the self-assembling pattern of an ink disposed on a glass surface as obtained by the method of another embodiment of the present invention; and
- Figure 5: presenting a view taken by a means of a light microscope showing the self-assembling pattern of an ink disposed on a polymeric film as obtained by the method of yet another embodiment of the present invention; and,
- Figure 6: presenting a view showing the printed pattern of ink disposed on a glass surface obtained by the method of another embodiment of the present invention.

1. A method for coating a substrate by conductive and/or transparent nano-powders in either ordered or random pattern, wherein said pattern is obtained either spontaneously or as a result of a printing technique.
2. The method according to item 1, useful for the production of conductive and transparent coatings comprising metal nano-powders, said method comprising;
   a. admixing metal nano powder in a solvent with at least one ingredient of the group selected from: binder, surfactant, additive, polymer, buffer, dispersant and/or coupling agent in the manner a homogenized solution is obtained;
   b. applying the homogenized mixture obtained above on a surface to be coated;
   c. evaporating the solvent from said homogenized mixture; and,
   d. sintering the coated layer providing a conductive and transparent coating on top of said surface.
3. The method according to item 2, wherein the metal nano powder is selected from at least one of the group: metal nano powder, metal nano powder with metal colloids; metal nano powder with a metal reducible salt and/or organic metal complexes and/or organo-metal compounds which decompose to form conductive materials.
4. The method according to item 3, wherein the concentration of the metal nano powder in the admixed solution is between 1% (wt) to 50% (wt).
5. The method according to item 3, wherein the concentration of the metal nano powder in the admixed solution is between 2% (wt) to 10% (wt).
6. The method according to item 2, wherein the admixed solution comprising organic solvent or a mixture of organic solvents, characterized by an evaporation rate lower then the evaporation rate of water.
7. The method according to item 2, wherein the concentration of the organic solvent or the mixture of organic solvents in the admixed solution is between 20% (wt) to 85% (wt).
8. The method according to item 2, wherein the concentration of the organic solvent or the mixture of organic solvents in the admixed solution is between 40% (wt) to 80% (wt).
9. The method according to item 2, wherein the solvent is selected from at least one of the group of petroleum ether, hexane, heptanes, toluene, benzene, dichloroethane, trichloroethylene, chloroform, dichloromethane, nitromethane, dibromomethane, cyclopentanone, cyclohexanone or any mixture thereof
10.The method according to item 2, wherein the concentration of the binder in the admixed solution is between 0% (wt) to 3% (wt).
11.The method according to item 2, wherein the binder is selected from ethyl cellulose and/or modified urea.
12.The method according to item 1, useful for the production of conductive and transparent ink comprising metal nano-powders, said method comprising;
   a. admixing metal nano powder in a solvent with at least one ingredient of the group selected from: binder, additive, polymer, buffer, oxidizing agent, dispersant and/or coupling agent in the manner a homogenized solution is obtained;
   b. dispersing a surfactant solution in a water miscible solvent or mixture of water miscible solvents so an emulsion is obtained;
   c. admixing said homogenized mixture in said emulsion;
   d. spreading the homogenized mixture obtained above on said surface to be coated;
   e. evaporating the solvent from said homogenized mixture in the manner that a self-assembled network-like pattern is developed *in situ*; and,
   f. sintering the network-like pattern providing a conductive and transparent ink.
13.The method according to items 2 or 12, wherein the concentration of the surfactant or surfactants mixture is between 0% (wt) to 4% (wt).
14.The method according to item 12, wherein the concentration of the surfactant or surfactants mixture in the dispersed emulsion is between 0% (wt) to 4% (wt)
15.The method according to item 12, wherein a W/O emulsion is obtained.
16.The method according to item 12, wherein the concentration of the water miscible solvent or mixture of water miscible solvents in the dispersed emulsion is between 5% (wt) to 70% (wt).
17.The method according to item 12, wherein the surfactant or surfactants mixture comprising at least one of the group of non ionic and ionic compounds, selected from SPAN-20, SPAN-80, glyceryl monooleate, sodium dodecyl sulfate, or any combination thereof.
18.The method according to item 12, wherein the concentration of the water miscible solvent or mixture of water miscible solvents in the dispersed emulsion is between 15% (wt) to 55% (wt).
19.The method according to item 12, wherein the water miscible solvent is selected from at least one of the group of water, methanol, ethanol, ethylene glycol, glycerol, dimethylformamid, dimethylacetamid, acetonitrile, dimethylsulfoxide, N-methylpyrrolidone or any mixture thereof.
20.The method according to item 1, wherein the surface to be coated is selected from glass, either flexible or relatively non-flexible polymeric films or sheets, polyethylene products, polypropylene, acrylate containing products, PMMA, their co-polymers or any combination thereof.
21.The method according to item 20, wherein the polymeric film comprising at least one of the group of polyesters, polyamides, polycarbonates, polyethylene, polypropylene, their copolymers or any combination thereof.
22. The method according to item 2, additionally comprising the step of treating the surface to be coated by a means of corona treatment and/or coating by primer.
23.The method according to item 22, wherein the primer is selected from at least one of the group of 3-aminopropyl triethoxy silane, phenyl trimethoxysilane, glycidyl trimethoxysilane, commercially available Tween products, Tween-80, neoalkoxy tri(dioctylpropylphosphato) titanate or any combination thereof.
24.The method according to item 1 wherein the nano-powder comprising metal or a mixture of metals selected from silver, gold, platinum, palladium, nickel, cobalt, copper or any combination thereof.
25.The method according to item 2 wherein polymer to be admixed in the homogenized solution are water miscible polymers.
26.The method according to item 1 wherein the nano-powder comprising metal is admixed with metal colloids; metal nano powder with a metal reducible salt and/or organic metal complexes and/or organo-metal compounds which decompose to form conductive materials
27.The method according to item 2, comprising the step of polymerizing a monomer in the presence of catalyst and/or oxidizing agent and/or reducing agent, in the manner a water miscible polymer is obtained in the homogenized solution.
28.The method according to item 2, wherein the spreading of the homogenized mixture on a surface to be coated is provided by a means selected from simple spreading; bar spreading, immersing; spin coating; doping and/or dipping.
29.The method according to item 28, wherein the coating layer or layers provided by the spreading of the homogenized mixture on a surface to be coated is characterized by a wet thickness of 5 to 200 microns.
30. The method according to item 2, wherein the sintering of the evaporated homogenized solution is provided in the temperature range of 50°C to 300°C for 0.5 to 2 hours.
31.The method according to item 12, wherein the sintering of the network-like pattern is provided in the temperature range of 50°C to 150°C for 2 to 30 minutes.
32.A conductive and transparent coating layer comprising metal nano powders, produced in the method as defined in item 1.
33. A conductive and transparent coating layer comprising metal nano powders, produced in the method as defined in item 2.
34.A conductive and transparent ink characterized by self-assembled network pattern, produce in the method as defined in item 12.
35.The conductive and transparent coating according to items 32 or 33, characterized by light transparencies in the range of 30% to 95% at 400 nm to 700 nm wavelength; resistances in the range of 0.1 Ω/square to 20 kΩ /square and by haze value in the range of 0.5% to 10%.
36.The conductive and transparent ink according to item 34, characterized by light transparencies in the range of 10% to 90% at 400 nm to 700 nm wavelength;; resistances in the range of 0.1 Ω /square to 1,000 Ω /square, and by a haze value in the range of 0.1 % to 5%.
37.The conductive and transparent coating layer according to items 32-34, characterized by either ordered or random patterns, wherein said patterns are provided by printing, ink-jet printing, ink-jet disposition, self-assembling or self organizing.
38. The conductive and transparent coating layer or a multiple layer array according to item 37, further characterized by that it provided a protective layer, anti-scratch layer, a layer of an enhance conductivity , a layer of an enhance adhesion to a surface to be coated or any combination thereof.
39.The conductive and transparent coating layer or a multiple layer array according to item 37, adapted to be use in at least one of the group of screens, displays, electrodes, PCBs, ink-jet products, ink-jet disposition products smart cards, RFID, antenna, thin-film transistors, LCDs or any combination thereof.

### DETAILED DESCRIPTION OF THE INVENTION

The following description is provided, along all chapters of the present invention, so as to enable any person skilled in the art to make use of said invention and sets forth the best modes contemplated by the inventor of carrying out this invention. Various modifications, however, will remain apparent to those skilled in the art, since the generic principles of the present invention have been defined specifically for a method for the production of metal nano powders coatings and inks and for all products produced thereby.

A novel method for the production of conductive and transparent coatings and inks comprising metal nano-powders (i.e., coatings or inks) is hereby presented. The hereto defined method takes full advantage of the fact that nano sized particles and grains have much larger surface areas than bulk materials, have special optical properties and can be worked to produce a conductive phase. It is according to the present invention that by coating a substrate with an "ink", solution or paste that was previously dispersed, cost-effective nano conductive materials and/or conductive transparent coating are produced. Those coatings and inks are generally characterized by (1) light transparencies between 40% to 90% in the visible range of about 400nm to 700nm wavelength; by (2), resistances between 0.1 Ω /square to 9 kΩ /square, and (3), by a relatively low haze values, generally ranges from 1% to 10%.

The term 'coating' is referring according to the present invention to any conductive and transparent optical layer produced in the manner of admixing metal nano powder in a solvent with at least one ingredient of the group: binder, surfactant, additive, polymer, buffer, dispersant and/or coupling agent in the manner a homogenized solution is obtained; spreading the homogenized mixture obtained above on a surface to be coated; evaporating the solvent from said homogenized mixture; and than sintering the coated layer so a conductive and transparent coating is obtained on top of said surface.

The term 'ink' is referring according to the present invention to any ink containing nano-powders of metal or metals, especially emulsion based compositions provided for coloring materials, or alternatively, to legend ink (marking ink) suitable for printing on printed circuit boards (PCB's).

More specifically, the term 'ink' is referring according to the present invention to any conductive and transparent topical pattern produced in the manner of admixing metal nano powder in a solvent with at least one ingredient of the group: binder, additive, polymer, buffer, dispersant and/or coupling agent in the manner a homogenized solution is obtained; admixing said homogenized mixture with water or water miscible solvent or mixture of water miscible solvents in the manner a W/O type emulsion is obtained; spreading the homogenized mixture obtained above on said surface to be coated; evaporating the solvent from said homogenized mixture in the manner that a self-assembled network-like pattern is developed *in situ*; and than sintering the network-like pattern so a conductive and transparent ink is obtained.

The inks (e.g., ink paste, inks, solutions, coatings) according to the present invention are especially adapted for use in or on top of transparent substrates. The aforementioned ink is adapted for coating, covering, immersing, dipping, and/or entrapping on top or into either solid or semi-solid matrix, or by means of any other suitable technique on such as glass or any polymer matrix, including flexible, semi-flexible or rigid materials. Due to their significant transparency in the visible wavelength range of about 400nm to 700nm, the aforementioned conductive ink is especially useful for screens, displays, liquid crystalline displays, smart cards and/or for any technology using ink-jets printers or any other technology of printing electronic matter.

The coating techniques that we have used are screen-printing, manual applicator and manual spreading. Other suitable techniques such as spin coating, spray coating, ink jet printing, offset printing and any suitable technique can also be used. Any type of transparent and non-transparent substrate can be coated for example glass, polycarbonate, polymer films and others.

Various ink/paste and coating systems have been found useful to produce a transparent-conductive coating, which differ in the formulation concept, and main ingredients leading to the conductivity and transparency. The main ingredients are selected from metal nano powder; metal nano powder with metal colloids; metal nano powder with a metal reducible salt; and/or organic metal complexes and/or organo-metal compounds which decompose to form conductive materials and all the above in a self-organizing system.

These nano metal based coating systems achieve light transmittances of up to 95% (measured between 400 nm and 700 nm), low haze values, with resistances as low as 1 Ω /square.

The ink or pastes are prepared according to the general procedure described bellow. Care has to be taken to achieve a good dispersion of the conductive additives (metal nano powders, salts, colloids and other additives).

The substrate is coated with the ink or paste. The coating can be performed in the different techniques previously described. The technique is chosen to enable control of physical parameters such as thickness and printed geometries (to obtain the desired transmittance and resistance). Sample may be heated, to obtain the desired resistance, to between 50°C to 300°C for 0.5 to 2 hours.

The term 'sintering' is referring according to the present invention to any process of forming objects from a metal powder by heating the powder at a temperature below its melting point. In the production of small metal objects it is often not practical to cast them. Through chemical or mechanical procedures a fine powder of the metal can be produced. When the powder is compacted into the desired shape and heated, i.e., sintered, for up to three hours, the particles composing the powder join together to form a single solid object

### EXAMPLES

Examples for formulations for each method are described bellow. These are only representative examples and are described hereby to demonstrate the wide range of possibilities this invention covers, by which we can use the special properties of nano metal powders. It is further acknowledged that the formulations of the hereto-described examples may similarly be made with different binders, solvents, metal powders, additives, polymers, buffers, surfactants, dispersants and/or coupling agents. Nevertheless, according to the present invention, nano powder metals and/or nano powder metal salts characterized by small particle size (D₉₀ < 0.1 µm) which are conductive are especially preferred. Concentrations can be adjusted to control the viscosity and the resistance and transparency of the coated substrate.

### Example 1

Admixing a binder, e.g., ethyl cellulose, 13% by weight, in a solvent, e.g., aromatic esters and aldehydes, preferably terpinol. Further homogenizing 25 parts by weight of the obtained binder solution by a means of a high rpm homogenizer the following materials: Silver nano-powder (D₉₀ < 0.1 µm), 50% (*w*/*w*), a solvent such as terpinol 20% (*w*/*w*) and a coupling agent, e.g., isopropyl dioleic(dioctylphosphato)titanate, also know a the commercially available NDZ-101 KRTTS, 1% (*w*/*w*).

### Example 2

Admixing metals nano powder, e.g., colloidal silver, 12% (*w*/*w*), a binder which is an adhesion promoter, such as Polyvinyl Pyrrolidone (PVP), 2.5% (*w*/*w*), and water, 32% (*w*/*w*). All components are intensively mixed by a means of an ultrasonic energy and/or high rpm dispersing equipment. Separately, Admixing metals nano powder, e.g., silver nano powder (D₉₀ < 0.1 µm), 14% (*w*/*w*), solvent, such as ethanol, 39.5% (*w*/*w*), by a means of a high rpm homogenizer. Finally, admixing solution obtained in first step with the solution obtained in the second step, so a homogenized solution is obtained.

### Example 3

Admixing metals nano powder, e.g., silver formate salt -1 parts by weight, a dispersant, e.g., trioctylphoshine oxide (TOPO), 2% (*w*/*w*) in a solvent, e.g., ethyl Acetate, 80% (*w*/*w*). Heating the solution to about 60°C until all components dissolve. Admixing metals nano powder, e.g., silver powder (D₉₀ < 0.1 µm), 17% (*w*/*w*) into the brown solution obtained in the first step, and subsequently homogenizing the obtained mixture by a means of a high rpm homogenizer.

### Example 4

Admixing metals nano powder, e.g., dissolve silver nitrate, 4% (*w*/*w*) in a buffer, e.g., ammonia, 25% solution, 9.5% (*w*/*w*). Further admixing water, 47% (*w*/*w*) and a dispersant, such as poly-carboxylic ammonium salt (e.g., the commercially available T1124 product), 3.5% (*w*/*w*), solvent, e.g., ethanol, 24% (*w*/*w*) and metals nano powder, e.g., silver powder (D₉₀ < 0.1 µm), 12% (*w*/*w*) and subsequently homogenizing the obtained mixture by a means of a high rpm homogenizer.

The optical and resistance data for metal nano powders coatings and inks produced in the hereto-defined examples are hereto provided:

**Table 1: Optical and resistance data for nano metal powders coatings and inks**

| Example No. | Printing Geometry | Transmittance % | Resistance Ω /square | Haze % | Remarks |
|---|---|---|---|---|---|
| Blank | | 92 | | 8 | Glass slides |
| 1 | Screen | 60-90 | 4- 100 | 0.5-2 | UV opacity |
| 2 | Continuous | 20-85 | 2-4000 | 1-10 | UV opacity |
| 3 | Continuous | 30-90 | 10-1200 | 1-10 | UV opacity |
| 4 | Continuous | 55-90 | 150-8000 | 1-6 | UV opacity |

Light transmittance measured between 400nm and 700nm. Heat treatment was provided at 280°C for about one hour.

It is hence according to another embodiment of the present invention, to present a new and simple method of producing transparent and conductive coating and inks on top or in glass and/or polymeric surfaces. This novel method is based on spreading of a predetermined mixture defined above on the surface to be coated. While an organic solvent is evaporated from the spread mixture, the self-assembled network-like pattern is developed *in situ*, i.e., on the surface. After drying is completed, the developed pattern is sintered at relatively low temperatures, e.g. at a temperature ranges from 50°C to 150°C for about 2 to 30 minutes. The final resistance of conductive layer lies in the range of about 1 to 1,000 Ohm/square, light transmittance is in the range of about 50 to 95%, and the haze value is in the range of about 0.5 to 5%.

The said special mixture is a *W*/*O* type emulsion of water or water miscible solvent (or a mixture of these solvents) in a suspension of metal fine particles in an organic solvent or mixture of two or more solvents not miscible with water.

It is according to this embodiment of the present invention, wherein the mixture also contents at least one emulsifying agent, binder or any mixture thereof. Hence, the dispersed phase is selected, according to yet another embodiment of the present invention from the group comprising yet not limited to water, methanol, ethanol, ethylene glycol, glycerol, dimethyl formamid, dimethyl acetamid, acetonitrile, dimethyl sulfoxide, N-methyl pyrrolidone and/or other water miscible solvents.
According to yet another embodiment of the present invention, the continuous phase is selected from the group comprising yet not limited to petroleum ether, hexanes, heptanes, toluene, benzene, dichloroethane, trichloroethylene, chloroform, dichloromethane, nitromethane, dibromomethane, cyclopentanone, cyclohexanone or any mixture thereof. Preferably, the solvent or solvents used in this continuous phase are characterized by higher volatility then that of the dispersed phase.

Similarly, the emulsifying agents are selected from the group comprising yet not limited to non ionic and ionic compounds, such as the commercially available SPAN-20, SPAN-80, glyceryl monooleate, sodium dodecylsulfate, or any combination thereof. Moreover, the binders are selected, yet not limited to modified cellulose, such as ethyl cellulose MW 100,000-200,000, modified urea, e.g., the commercial available BYK-410, BYK-411, BYK-420 produced by BYK-Chemie ltd.

It is according to yet another embodiment of the present invention, wherein the metal fine particles and nano-powders are selected, yet not limited to silver, gold, platinum, palladium, nickel, cobalt, copper or any combination thereof, wherein said metal or mixture of metals is characterized by an average particle size smaller then 1 micron, better smaller than 0.5 and most preferably smaller then 0.1 micron. The small particle size provides the improved optical properties of the coatings obtained in the method provided by the present invention. According to one specifically preferred embodiment the present invention, the aforementioned metal or mixture of metals is selected from precious metals due to their enhanced chemical stability and improved electrical conductivity.

**Table 2. Basic mixture formulation of the nano-inks and nano-powders obtained by the method as defined and described in the above mentioned examples.**

| Component | Min. content, % | Max. content, % |
|---|---|---|
| Organic solvent or mixture | 40 | 80 |
| Binder | 0 | 3 |
| Emulsifying agent | 0 | 4 |
| Metal powder | 2 | 10 |
| Water miscible solvent or mixture | 15 | 55 |

The mixture should be prepared be the following way: Emulsifying agent and/or binder dissolved in organic solvent or mixture and metal powder added. Metal powder should be dispersed in organic phase by ultrasonic treatment, high shear mixing, high speed mixing or any other way used for preparation of suspensions and emulsions. After this water miscible solvent or mixture added and W/O type emulsion prepared by ultrasonic treatment, high shear mixing, high speed mixing or any other way used for preparation emulsions.

The mentioned above self-assembled network pattern can be developed on different surfaces: glass, polymeric films and sheets (polyesters, polyamides, polycarbonates, polyethylene, polypropylene etc.). The surface to be coated may be both untreated and treated for surface properties changing (corona treatment or coating by primer). As primers may be used 1-2% acetone or hexane solutions of 3-Aminopropyl Triethoxy silane, Phenyl Trimethoxysilane, Glycidyl Trimethoxysilane, Tween-80, Neoalkoxy Tri(dioctylpropylphosphato) titanate etc.). Coating techniques may be following simple spreading, spin coating, dipping). Wet thickness of coating - from 5 to 200 microns.

Additional technique of polymeric films coating is a developing of self-assembled network on glass and printing of the pattern on polymer.

### Example 5

Admixing a surfactant such as SDS, 0.1g in 40 g of water. Admixing than a binder, e.g., ethyl cellulose, 1g, in a solvent, e.g., in toluene, 60g and nano powder metals, e.g., silver nano-powder (D₉₀ < 0.1 µm), 8g. Than, homogenizing the obtained solution by a means of ultrasonic energy and/or high rpm dispersing equipment. Lastly, admixing 31 g of the solution obtained by the first step with the solution obtained by the second step.

### Example 6

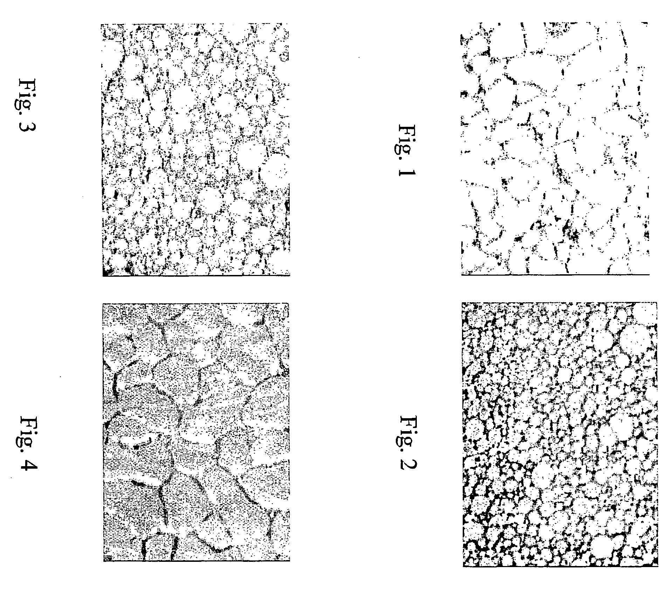

Admixing a metals nano powder, e.g., silver powder (maximal particle size is lower 0.12 micron), 4 g; a solvent, e.g., 1,2-Dichloroethane, 30 g; a binder, e.g., BYK-410, 0.2 g; and homogenizing the solution by a means of an ultra sound at 180W power for 1.5 min. admixing distillated water, 15g and homogenizing the obtained emulsion by an ultra sound means at 180W power for 30 sec. This formulation was printed on glass surface and provided good developed network with big cells (above 40µ up to 70µ and lines about 2-6µ width). Resistance was in the range of 7 to 40 Ω/square, transparency from 72 to 81 %, and haze value between 0.8 to 1.8%. Reference is made now to Fig. 1, presenting a view taken by a means of a light microscope showing the pattern on glass surface as obtained by the method as described in example 6.

### Example 7

Admixing metals nano powder, e.g., silver powder (maximal particle size is lower 0.12 micron), 4 g; a solvent, e.g., toluene, 30 g, a binder, e.g., BYK-410, 0.2 g homogenizing the solution by a means of an ultra sound at 180W power for 1.5 min. admixing distillated water, 15g and homogenizing the obtained emulsion by an ultra sound means at 180W power for 30 sec. This formulation printed on glass surface gives good developed network with small cells (about 10µ and lines about 1 to 4µ width). Resistance was in the range of 7 to 40 Ω/square, transparency was between 45 to 65%, and haze value between 1.5 to 3.0% after sintering at 150°C for 5 min. Reference is made now to Fig. 2, presenting a view taken by a means of a light microscope showing the pattern on glass surface as obtained by the method as described in example 7.

### Example 8

Admixing a binder, e.g., BYK-410, 0.06 g; a surfactant, e.g., SPAN-80, 0.03g; a solvent, e.g., cyclopentanone, 0.8g and toluene, 16g; nano powder metals, e.g., silver powder (maximal particle size is lower 0.12 micron), 0.8g and homogenizing the obtained solution by an ultra sound means at 180W power for 30 seconds. Admixing distillated water, 9ml and homogenizing the obtained emulsion by an ultra sound means at 180W power for 20sec. This formulation was printed on glass pretreated with 1% acetone solution of 3-aminopropyl triethoxy silane and gave good developed network with cells of 40µ to 70µ and lines about 2 to 6 µ width. Resistance was between 2 to 16 Ω/square, transparency was between 72 to 81%, haze value was between 0.8 to 1.8% after sintering at 50°C for 30 min in formic acid vapor. The pattern printed from glass to different polymeric films almost doesn't change electrical and optical properties.

### Example 9

Admixing metals nano powder, e.g., silver powder (maximal particle size is lower 0.12 micron), 4g; a solvent, e.g., trichloroethylene, 30g; a binder, e.g., BYK-410, 0.2g; and homogenizing the obtained solution by an ultra sound means at 180W power for 1.5 min. Admixing distillated water, 15ml and homogenizing the obtained emulsion by an ultra sound means at 180W power for 30 sec. This formulation was printed on glass surface and gave good developed network with small cells: about 10 to 40µ and lines of about 2 to 4µ width). Resistance was between 7 to 40 Ω/square, and transparency was 45 to 65% after sintering at 150°C for 5 min. This formulation provided useful also in the case when high-speed stirrer (Premier-type) is used instead of the ultra sound sonication. In this case, the obtained network cells are bigger and the transparency is improved. This formulation also has better performance while printed on polymer films not dissolved by trichloroethylene, such s PET, PEN, polyethylene. Reference is made now to Fig. 3, presenting a view taken by a means of a light microscope showing the pattern on glass surface as obtained by the method as described in example 9.

### Example 10

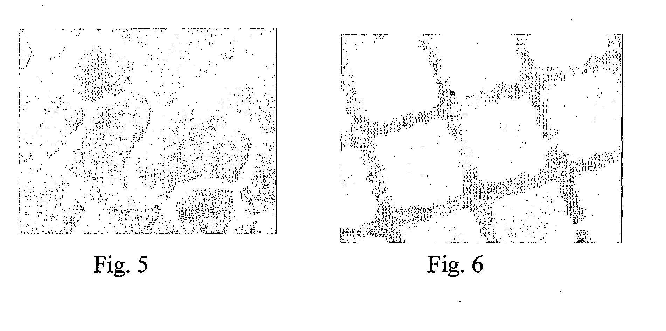

Admixing a binder, e.g., BYK-410, 0.06g; a surfactant, e.g., SPAN-20, 0.03g, a solvent mixture, such as cyclohexanone, 0.8g and trichloroethylene, 24g; metals nano powder, e.g., silver powder (maximal particle size is lower 0.12 micron), 1g and homogenizing the obtained solution by an ultra sound means at 180W power for 30 sec. Admixing distillated water, 9ml and homogenizing the obtained emulsion by an ultra sound means at 180W power for 20 sec. This formulation was printed on glass pretreated with 1% acetone solution of 3-aminopropyl triethoxy silane and gave good developed network with cells of 50µ up to 100µ, and lines about 2 to 8µ width. Resistance was 1.8-10 Ω/square, transparency 79-86%, haze value 1.8 to 2.8% after sintering at 50°C for 30 min in formic acid vapor. Reference is made now to Fig. 4, presenting a view taken by a means of a light microscope showing the pattern on glass surface as obtained by the method as described in example 10. The pattern printed on various polymeric films and did not change electrical and optical properties significantly. Reference is made now to Fig. 5, presenting a view taken by a means of a light microscope showing the pattern on polymeric film as obtained by the method as described in example 10.

### Example 11

Admixing a binder, e.g., BYK-411, 0.06 g; a surfactant, e.g., SPAN-80, 0.2 g; a solvent mixture, e.g., cyclohexanone,1 g and petroleum ether, 10 g; metals nano powder, e.g., silver powder (maximal particle size is lower 0.12 micron), 1g and homogenizing the obtained solution by an ultra sound means at 180W power for 30 sec. Admixing distillated water, 7ml and homogenizing the obtained emulsion by an ultra sound means at 180W power for 20 sec. This formulation was printed on polyimide polymer pretreated with 1% acetone solution of phenyl trimethoxysilane and gave a good developed network characterized by cells of above 20µ up to 60µ, and lines about 2 to 6µ width. The resistance was between 20 to 30 Ω/square, transparency 68 to 78%, and the haze value was between 8 to 10% after sintering at 150°C for 5 min.

## Claims

1. A method for the production of transparent and conductive coatings comprising metal nano-powders, said method comprising:
a. admixing metal nano-powder in an organic solvent with at least one ingredient of the group selected from binder, surfactant, additive, polymer, buffer, dispersant, and/or coupling agent in the manner that a homogenized mixture is obtained;
b. admixing the homogenized mixture with water, water-miscible solvent, or mixture of water-miscible solvents in the manner that a water/oil (W/O) type emulsion is formed;
c. applying the emulsion mixture on a surface to be coated;
d. evaporating the solvent from the emulsion in the manner that a self-assembled network-like pattern is developed *in situ;* and
e. sintering the network-like pattern to form a transparent and conductive coating on the surface.

2. The method according to claim 1, wherein the sintering step is conducted at a temperature in the range of 50°C to 150°C for 2 to 30 minutes.

3. The method according to claim 1, wherein the concentration of the metal nano-powder in the homogenized mixture is between 1% (wt) and 50% (wt).

4. The method according to claim 1, wherein the concentration of the metal nano-powder in the homogenized mixture is between 2% (wt) and 10% (wt).

5. The method according to claim 1, wherein the emulsion comprises an organic solvent or mixture of organic solvents **characterized by** an evaporation higher than the evaporation rate of water.

6. The method according to claim 1, wherein the concentration of water, water-miscible solvent, or mixture of water-miscible solvents in the emulsion is between 5% (wt) and 70% (wt).

7. The method according to claim 1, wherein the concentration of water, water-miscible solvent, or mixture of water-miscible solvents in the emulsion is between 15% (wt) and 55% (wt).

8. The method according to claim 1, wherein the surface to be coated is selected from glass, flexible polymeric films or sheets, relatively non-flexible polymeric films or sheets, polyethylene products, polypropylene products, acrylate-containing products, polymethylmethacrylate (PMMA), their copolymers, and combinations thereof.

9. The method according to claim 1, wherein the surface to be coated is a polymeric film selected from polyesters, polyamides, polycarbonates, polyethylene, polypropylene, copolymers thereof, and combinations thereof.

10. The method according to claim 1, wherein the metal nano-powder is selected from silver, gold, platinum, palladium, nickel, cobalt, copper, or combination thereof.

11. The method according to claim 1, wherein the metal nano-powder is **characterized by** a D₉₀ value of less than 0.1 µm.

12. The method according to claim 1, wherein the metal nano powder is selected from at least one of the group: metal nano powder; metal nano powder with metal colloids; metal nano powder with a metal reducible salt and/or organic metal complexes and/or organo-metal compounds which decompose to form conductive materials.

13. The method according to claim 1, comprising applying the emulsion to the surface according to an ordered or random pattern.

14. The method according to claim 1, wherein the transparent and conductive coating is **characterized by** a light transparency between 40% and 90% in the visible range of 400 nm to 700 nm, a resistance between 0.1 ohms/square and 9,000 ohms/square, and a haze value between 1% and 10%.

15. A conductive and transparent coating produced according to the method of claims 1-14.

16. A conductive and transparent coating according to claim 15, wherein the coating is incorporated in a screen, display, electrode, printed circuit board (PCB), smart card, RFID article, antenna, thin-film transistor, LCD, or combination thereof.

## Patentansprüche

1. Verfahren zur Herstellung transparenter und leitfähiger Beschichtungen, die Metallnanopulver aufweisen, wobei das Verfahren aufweist:
a. Mischen von Metallnanopulver in einem organischen Lösungsmittel mit mindestens einem Bestandteil der Gruppe, die aus Bindemittel, oberflächenaktivem Stoff, Additiv, Polymer, Puffer, Dispersant und/ oder Haftvermittler ausgewählt ist, auf die Weise, daß eine homogenisierte Mischung erhalten wird;
b. Mischen der homogenisierten Mischung mit Wasser, wassermischbarem Lösungsmittel oder Mischung aus wassermischbaren Lösungsmitteln auf die Weise, daß eine Wasser-Öl- (W/Ö-) artige Emulsion gebildet wird;
c. Auftragen der Emulsionsmischung auf eine zu beschichtende Oberfläche;
d. Verdampfen des Lösungsmittels aus der Emulsion auf die Weise, daß ein selbstorganisiertes netzartiges Muster *in situ* entwickelt wird; und
e. Sintern des netzartigen Musters, um eine transparente und leitfähige Beschichtung auf der Oberfläche zu bilden.

2. Verfahren nach Anspruch 1, wobei der Sinterschritt 2 bis 30 Minuten bei einer Temperatur im Bereich von 50 °C bis 150 °C durchgeführt wird.

3. Verfahren nach Anspruch 1, wobei die Konzentration des Metallnanopulvers in der homogenisierten Mischung zwischen 1 Gew.-% und 50 Gew.-% liegt.

4. Verfahren nach Anspruch 1, wobei die Konzentration des Metallnanopulvers in der homogenisierten Mischung zwischen 2 Gew.-% und 10 Gew.-% liegt.

5. Verfahren nach Anspruch 1, wobei die Emulsion ein organisches Lösungsmittel oder eine Mischung aus organischen Lösungsmitteln aufweist, das (die) durch eine Verdampfung **gekennzeichnet** ist, die höher als die Verdampfungsgeschwindigkeit von Wasser ist.

6. Verfahren nach Anspruch 1, wobei die Konzentration von Wasser, wassermischbarem Lösungsmittel oder Mischung aus wassermischbaren Lösungsmitteln in der Emulsion zwischen 5 Gew.-% und 70 Gew.-% liegt.

7. Verfahren nach Anspruch 1, wobei die Konzentration von Wasser, wassermischbarem Lösungsmittel oder Mischung aus wassermischbaren Lösungsmitteln in der Emulsion zwischen 15 Gew.-% und 55 Gew.-% liegt.

8. Verfahren nach Anspruch 1, wobei die zu beschichtende Oberfläche aus Glas, flexiblen Polymerfilmen oder -bahnen, relativ unflexiblen Polymerfilmen oder -bahnen, Polyethylenprodukten, Polypropylenprodukten, acrylathaltigen Produkten, Polymethylmethacrylat (PMMA), deren Copolymeren und deren Kombinationen ausgewählt ist.

9. Verfahren nach Anspruch 1, wobei die zu beschichtende Oberfläche ein Polymerfilm ist, der aus Polyestern, Polyamiden, Polycarbonaten, Polyethylen, Polypropylen, deren Copolymeren und deren Kombinationen ausgewählt ist.

10. Verfahren nach Anspruch 1, wobei das Metallnanopulver aus Silber, Gold, Platin, Palladium, Nickel, Cobalt, Kupfer oder deren Kombinationen ausgewählt ist.

11. Verfahren nach Anspruch 1, wobei das Metallnanopulver durch einen D₉₀-Wert unter 0,1 µm **gekennzeichnet** ist.

12. Verfahren nach Anspruch 1, wobei das Metallnanopulver aus mindestens einem Bestandteil der folgenden Gruppe ausgewählt ist: Metallnanopulver; Metallnanopulver mit Metallkolloiden; Metallnanopulver mit einem metallreduzierbaren Salz und/oder organischen Metallkomplexen und/ oder Organometallverbindungen, die sich zu leitfähigen Materialien zersetzen.

13. Verfahren nach Anspruch 1 mit Auftragen der Emulsion auf die Oberfläche gemäß einem geordneten oder zufälligen Muster.

14. Verfahren nach Anspruch 1, wobei die transparente und leitfähige Beschichtung durch eine Lichtdurchlässigkeit zwischen 40 % und 90 % im sichtbaren Bereich von 400 nm bis 700 nm, einen Widerstand zwischen 0,1 Ohm/Flächeneinheit und 9000 Ohm/Flächeneinheit sowie einen Schleierwert zwischen 1 % und 10 % **gekennzeichnet** ist.

15. Leitfähige und transparente Beschichtung, die gemäß dem Verfahren nach Anspruch 1 bis 14 hergestellt ist.

16. Leitfähige und transparente Beschichtung nach Anspruch 15, wobei die Beschichtung in einen Bildschirm, eine Anzeige, eine Elektrode, eine Leiterplatte (Platine), eine Smartcard, einen RFID-Artikel, eine Antenne, einen Dünnfilmtransistor, ein LCD oder deren Kombinationen eingebaut ist.

## Revendications

1. Procédé de production de revêtements transparents et conducteurs comprenant des nanopoudres de métal, ledit procédé comprenant les étapes consistant à :
a. mélanger une nanopoudre de métal dans un solvant organique avec au moins un ingrédient du groupe choisi parmi un liant, un agent tensioactif, un adhésif, un polymère, un tampon, un dispersant et/ou un agent de couplage de manière à obtenir un mélange homogénéisé ;
b. mélanger le mélange homogénéisé avec de l'eau, un solvant miscible à l'eau ou un mélange de solvants miscibles à l'eau de manière à former une émulsion de type eau/huile (E/H) ;
c. appliquer le mélange d'émulsion sur une surface à revêtir ;
d. évaporer le solvant de l'émulsion de manière à développer un motif de type réseau auto-assemblé *in situ* ; et
e. fritter le motif de type réseau pour former un revêtement transparent et conducteur sur la surface.

2. Procédé selon la revendication 1, dans lequel l'étape de frittage est conduite à une température dans la gamme de 50 °C à 150 °C pendant 2 à 30 minutes.

3. Procédé selon la revendication 1, dans lequel la concentration de la nanopoudre de métal dans le mélange homogénéisé est comprise entre 1 % (poids) et 50 % (poids).

4. Procédé selon la revendication 1, dans lequel la concentration de la nanopoudre de métal dans le mélange homogénéisé est comprise entre 2 % (poids) et 10 % (poids).

5. Procédé selon la revendication 1, dans lequel l'émulsion comprend un solvant organique ou mélange de solvants organiques **caractérisé par** une évaporation plus élevée que la vitesse d'évaporation de l'eau.

6. Procédé selon la revendication 1, dans lequel la concentration d'eau, de solvant miscible à l'eau ou de mélange de solvants miscibles à l'eau dans l'émulsion est comprise entre 5 % (poids) et 70 % (poids).

7. Procédé selon la revendication 1, dans lequel la concentration d'eau, de solvant miscible à l'eau ou de mélange de solvants miscibles à l'eau dans l'émulsion est comprise entre 15 % (poids) et 55 % (poids).

8. Procédé selon la revendication 1, dans lequel la surface à revêtir est choisie parmi le verre, les films ou feuilles polymères flexibles, les films ou feuilles polymères relativement non flexibles, les produits de poly(éthylène), les produits de poly(propylène), les produits contenant de l'acrylate, le poly(méthacrylate de méthyle) (PMMA), leurs copolymères et leurs combinaisons.

9. Procédé selon la revendication 1, dans lequel la surface à revêtir est un film polymère choisi parmi les poly (esters), les poly(amides), les poly-(carbonates), le poly(éthylène), le poly(propylène), leurs copolymères, et leurs combinaisons.

10. Procédé selon la revendication 1, dans lequel la nanopoudre de métal est choisie parmi l'argent, l'or, le platine, le palladium, le nickel, le cobalt, le cuivre ou leurs combinaisons.

11. Procédé selon la revendication 1, dans lequel la nanopoudre de métal est **caractérisée par** une valeur D₉₀ inférieure à 0,1 µm.

12. Procédé selon la revendication 1, dans lequel la nanopoudre de métal est choisie parmi au moins un élément du groupe : une nanopoudre de métal ; une nanopoudre de métal avec des colloïdes de métal ; une nanopoudre de métal avec un sel réductible par métal et/ou des complexes de métaux organiques et/ou des composés organométalliques qui se décomposent pour former des matériaux conducteurs.

13. Procédé selon la revendication 1, comprenant l'application de l'émulsion à la surface selon un motif ordonné ou aléatoire.

14. Procédé selon la revendication 1, dans lequel le revêtement transparent et conducteur est **caractérisé par** une transparence à la lumière comprise entre 40 % et 90 % dans la gamme visible de 400 nm à 700 nm, une résistance comprise entre 0,1 ohm/carré et 9 000 ohms/carré, et une valeur de voile comprise entre 1 % et 10 %.

15. Revêtement conducteur et transparent produit selon le procédé des revendications 1 à 14.

16. Revêtement conducteur et transparent selon la revendication 15, dans lequel le revêtement est incorporé dans un écran, un afficheur, une électrode, une carte de circuit imprimé (PCB), une carte à puce intelligente, un article RFID, une antenne, un transistor à couches minces, un LCD ou l'une de leurs combinaisons.
